# EUROPEAN PATENT SPECIFICATION

(11) **EP 4 489 067 B1**
(45) Date of publication and mention of the grant of the patent: **27.08.2025**
(21) Application number: 23183962.2
(22) Date of filing: 06.07.2023
(51) Int. Cl.: H01L 23/04, H01L 23/053, H01L 23/06, H01L 23/10, H01L 23/00, H01L 23/24, H01L 25/07, H01L 23/373, H01L 23/498

(54) **HOUSING, SEMICONDUCTOR MODULE AND METHODS FOR PRODUCING THE SAME**
GEHÄUSE, HALBLEITERMODUL UND VERFAHREN ZU DESSEN HERSTELLUNG
BOÎTIER, MODULE SEMI-CONDUCTEUR ET PROCÉDÉS DE PRODUCTION ASSOCIÉS

(43) Date of publication of application: 08.01.2025
(73) Proprietor: Infineon Technologies AG, 85579 Neubiberg (DE)
(72) Inventor: TROSKA, Georg, 58730 Fröndenberg/ Ruhr (DE)
(74) Representative: Westphal, Mussgnug & Partner, Patentanwälte mbB

(56) References cited:
- EP-A1- 4 057 335
- US-A1- 2022 310 536
- US-A1- 2023 187 291

## Description

### TECHNICAL FIELD

The instant disclosure relates to a housing, a semiconductor module comprising a housing, and to methods for producing the same.

### BACKGROUND

Document US 2022/310536 A1 discloses a housing for a power semiconductor module arrangement including sidewalls and a lid. The lid includes a first layer of a first material having a plurality of openings, and second layer of a second material that is different from the first material. The second layer completely covers a bottom surface of the first layer. The second layer includes a plurality of protrusions, each protrusion extending into a different one of the plurality of openings of the first layer such that each of the plurality of openings is completely covered by one of the protrusions.

Document US 2023/187291 A1 discloses a housing for a power semiconductor module including sidewalls and a top that includes a first surface extending in a first horizontal plane and a second surface opposite and in parallel to the first surface, a plurality of openings of a first kind, each of the plurality of openings of the first kind including a first through hole extending through the top from the first surface to the second surface, and a plurality of openings of a second kind, each of the plurality of openings of the second kind comprising a second through hole extending through the top from the first surface to the second surface. Each of the plurality of openings of the first kind includes a collar or sleeve. Each of the plurality of openings of the second kind includes a trench or indentation arranged adjacent to and forming a closed loop around the respective second through hole.

Document EP 4 057 335 A1 discloses a semiconductor package comprising a package body, at least one semiconductor chip arranged in the package body, and at least two electric terminals by means of which the at least one semiconductor chip is electrically connected, the at least two electric terminals protrude from the package body, wherein the package body comprises a first body compound and a second body compound, the first body compound has a lower comparative tracking index, CTI, than the second body compound, and the CTI of the second body compound is at least 100 larger than the CTI of the first body compound.

Power semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. Other semiconductor module arrangements are known which do not comprise substrates, e.g., semiconductor module arrangements using cooling structures with floating potentials.

The semiconductor substrate and the elements mounted thereon are usually electrically coupled to the outside of the housing by means of terminal elements. Such terminal elements are electrically coupled to the substrate or one or more of the elements mounted thereon with a first end, and extend from the substrate through the housing to the outside of the housing. A power semiconductor module arrangement usually comprises a plurality of such terminal elements. Different terminal elements may be coupled to the same or to different electrical potentials. If two terminal elements that are coupled to different electrical potentials are arranged close to each other, a creepage distance between the second ends of such terminal elements outside of the housing may be shorter than a minimal creepage distance. This may result in unwanted short-circuits that may negatively affect the operation of the power semiconductor module or even destroy the power semiconductor module arrangement.

There is a need for a housing and a power semiconductor module comprising a housing wherein a length of the creepage distances equals or is larger than a minimum creepage distance and that may be produced at comparably low costs.

### SUMMARY

The invention is set out in the appended set of claims.

A housing for a power semiconductor module arrangement includes sidewalls and a top, wherein the top includes a first layer of a first material including a plurality of openings, and a second layer of a second material that is different from the first material, wherein the second material has a comparative tracking index CTI that is higher than a comparative tracking index CTI of the first material, and at least one of the second layer partly covers at least one of a bottom surface of the first layer and a top surface of the first layer, and the first layer comprises at least one additional opening, each of the at least one additional opening being sealed by a section of the second layer such that the second layer forms at least one section of the housing.

A power semiconductor module includes a semiconductor substrate, at least one semiconductor body arranged on a top surface of the semiconductor substrate, and the housing, wherein the semiconductor substrate with the at least one semiconductor body arranged thereon is arranged within the housing or forms a bottom of the housing.

A method for forming a top of a housing includes forming a first layer of a first material including a plurality of openings, and forming a second layer of a second material that is different from the first material, wherein the second material has a comparative tracking index CTI that is higher than a comparative tracking index CTI of the first material, and at least one of the second layer partly covers at least one of a bottom surface of the first layer and a top surface of the first layer, and the first layer comprises at least one additional opening, each of the at least one additional opening being sealed by a section of the second layer such that the second layer forms at least one section of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a three-dimensional view of a power semiconductor module arrangement.
Figure 3 is a cross-sectional view of a section of a housing.
Figure 4 is a cross-sectional view of another section of a housing.
Figure 5, including Figures 5A to 5D, schematically illustrated cross-sectional views of sections of a housing according to embodiments of the disclosure, wherein Figures 5A to 5C do not fall under the scope of the present invention and Figure 5D falls under the scope of the present invention.
Figure 6 is a cross-sectional view of a power semiconductor module arrangement according to embodiments of the disclosure, wherein Figure 6 does not fall under the scope of the present invention.
Figure 7 is a cross-sectional view of another power semiconductor module arrangement according to embodiments of the disclosure.

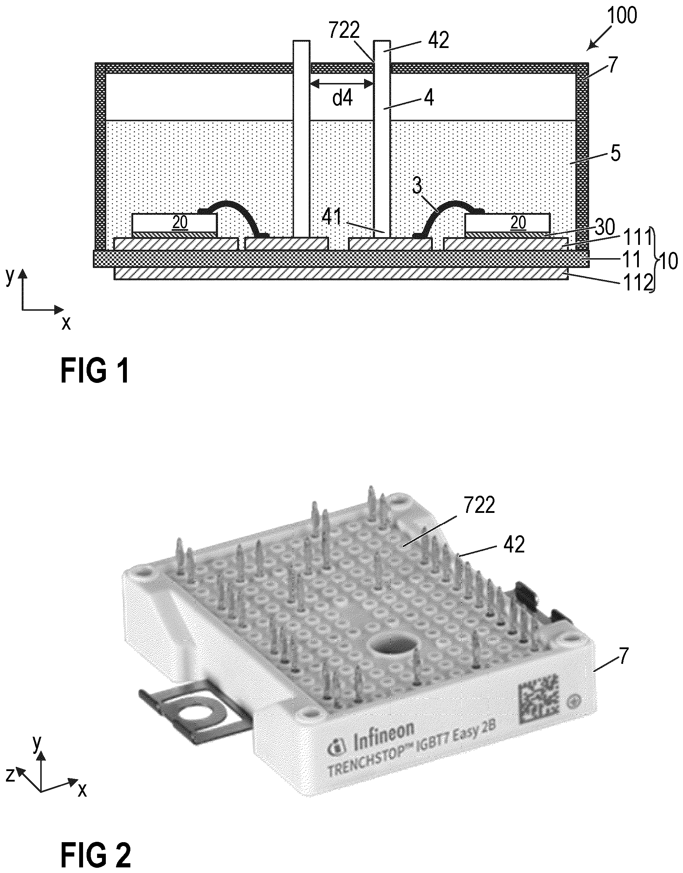

Figures 1 - 4, 5D and 7 fall within the scope of the present invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

Referring to Figure 1, a cross-sectional view of a power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 be arranged inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing. Other semiconductor module arrangements are known which do not comprise substrates, e.g., semiconductor module arrangements using cooling structures with floating potentials.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, or silver, for example.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 42, however, are not covered by the casting compound 5 and protrude from the casting compound 5, e.g., through through holes 722 of the housing 7, to the outside of the housing 7. The casting compound 5 is configured to protect the components and electrical connections inside the power semiconductor module 100, in particular inside the housing 7, from certain environmental conditions and mechanical damage. The casting compound 5 further provides for an electrical isolation of the components inside the housing 7. The casting compound 5 generally is chosen to have a very high CTI (e.g., 600V or more) such that it is able to guarantee a sufficient creepage distance between terminal elements 4 that are arranged close to each other (e.g., a creepage distance on the surface of the casting compound 5).

Figure 2 schematically illustrates a semiconductor module with a plurality of terminal elements 4 (second ends 42 of terminal elements) protruding out of the top of the housing 7. The top comprises a plurality of openings 722. Terminal elements 4 protrude out of some but not all of the openings 722. By providing a plurality of openings 722 in the top, one and the same housing 7 can be used for many different layouts or applications without the need for customizing the housing 7 for specific applications or customers. For example, each of the through holes 722 may have a round, square, or any other suitable cross-section, and each terminal element 4 may protrude (centrally) through one of the through holes 722. A housing 7 comprising more through holes 722 as are required, however, is only an example. A housing 7 may alternatively comprise the same number of through holes 722 as the number of terminal elements 4. That is, for each terminal element 4, a separate through hole 722 may be provided, but not more. According to other examples, terminal elements 4 can be considered being part of the housing 7. For example, terminal elements may be molded into the material forming the housing 7, or may be snapped into the housing 7 by means of suitable elements.

As can be seen in Figure 2, it is possible that different terminal elements 4 extend through neighboring through holes 722, or through through holes 722 that are arranged comparably close to each other. Terminal elements 4 are generally used to electrically contact the components inside the housing 7. One or more of the terminal elements 4, therefore, may be coupled to a first electrical potential while one or more different ones of the terminal elements 4 may be coupled to a second electrical potential during the use of the power semiconductor module arrangement. It is also possible that other terminal elements 4 are coupled to even further electrical potentials. It is not always possible to arrange terminal elements 4 that are connected to different electrical potentials distant to each other in the power semiconductor module arrangement. Therefore, it is possible that one first terminal element 4 is coupled to a first electrical potential (e.g., positive potential), while another terminal element 4 which is arranged close to the first terminal element 4 is coupled to a second electrical potential that is different from the first electrical potential (e.g., negative potential). In order to avoid short circuits, electric flashovers or breakthroughs between such neighboring (or close) terminal elements 4, the distance between two respective terminal elements 4 should be chosen such that a minimum creepage distance is achieved. The creepage distance generally is the shortest path along the surface of a solid insulating material between two conductive parts.

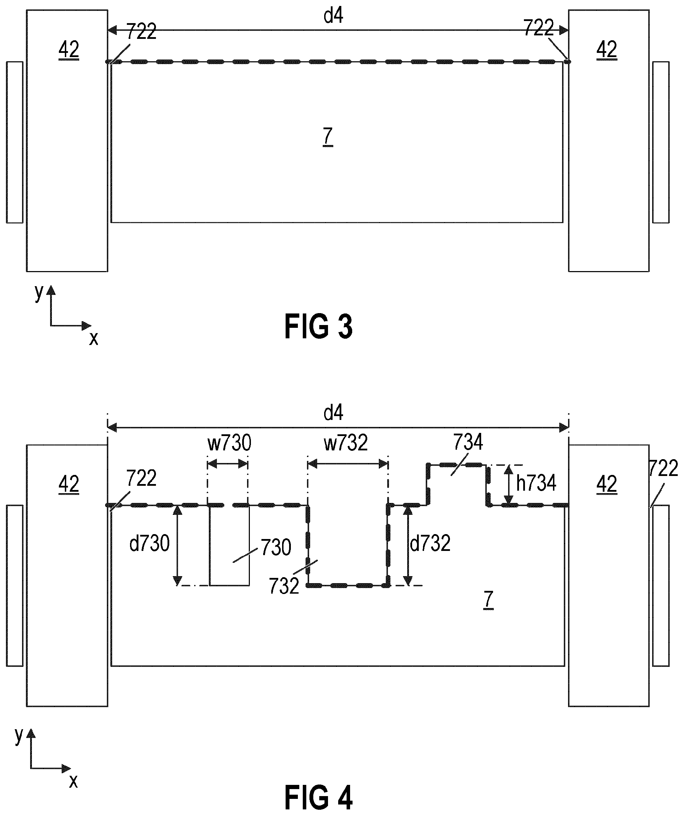

This is schematically illustrated for a flat surface in the cross-sectional view of Figure 3. Figure 3 schematically illustrates a section of a top of a housing 7 between two neighboring terminal elements 4. In this example, the creepage distance (illustrated in a dashed line) is defined by a direct path between the neighboring terminal elements 4. That is, the creepage distance corresponds to the shortest distance d4 between the terminal elements 4.

The creepage distance can be extended by providing trenches 730, 732 in and/or protrusions 734 on the surface of the top, for example. This is schematically illustrated in the cross-sectional view of Figure 4. The creepage distance may be extended by double the height h734 of a protrusion 734 and/or by double the depth d732 of a trench 732, if the width w732 of the trench 732 is larger than a minimum width. In the example illustrated in Figure 4, one of the trenches 730 has a width w730 that is less than the minimum width. Therefore, the depth d730 of this trench does not extend the creepage distance. The minimum width of a trench 730 that is necessary to achieve an extension of the creepage distance generally depends on different factors such as, e.g., a degree of contamination of the environment in which the power semiconductor module arrangement is mounted during operation. Different degrees of contamination may include clean room environment, normal environment, or highly contaminated environment, for example. In a normal environment, the minimum width that is required for a trench to be able to extend the creepage distance may be 1mm, for example. This minimum width may be shorter in a clean room environment, and longer in a highly contaminated environment.

The required creepage distance further depends on the material of the respective surface. Different materials do have different properties such as, different comparative tracking indices CTIs, for example. The CTI is a scaling factor which is required for the correct calculation of the creepage distance. Especially for power semiconductor modules with very high requirements concerning the electrical isolation, a material having a high CTI may be required. Generally, it can be said that the higher the CTI, the shorter the minimum creepage distance. Another important property of a material used for the top of a housing 7 is the relative temperature index RTI, for example. The RTI of a material generally defines the maximum temperature at which the critical properties of a material will still remain within acceptable limits over a long period of time.

Materials having a high CTI are generally more expensive than materials having a lower CTI. Even further, materials having both a high CTI and a high RTI are rare and even more expensive or are not stable concerning mechanical requirements for housings used for power semiconductor module arrangements (as is the case, e.g., with silicone materials which are usually not hard enough for power semiconductor module housings). Therefore, in order to keep the overall costs of a power semiconductor module arrangement at a minimum, materials are often used that have either a high CTI or a high RTI, but not both. If a material having a low CTI is used to form the housing 7, either a minimum distance dₘᵢₙ between different terminal elements 4 being connected to different potentials is comparably large (d4 ≥ dₘᵢₙ), or a very sophisticated top is needed with many trenches 732 and/or protrusions 734 which is generally difficult to produce and only at high production costs. In some cases, it might not even be possible to create a geometry of the housing fulfilling the requirements concerning the minimum creepage distance.

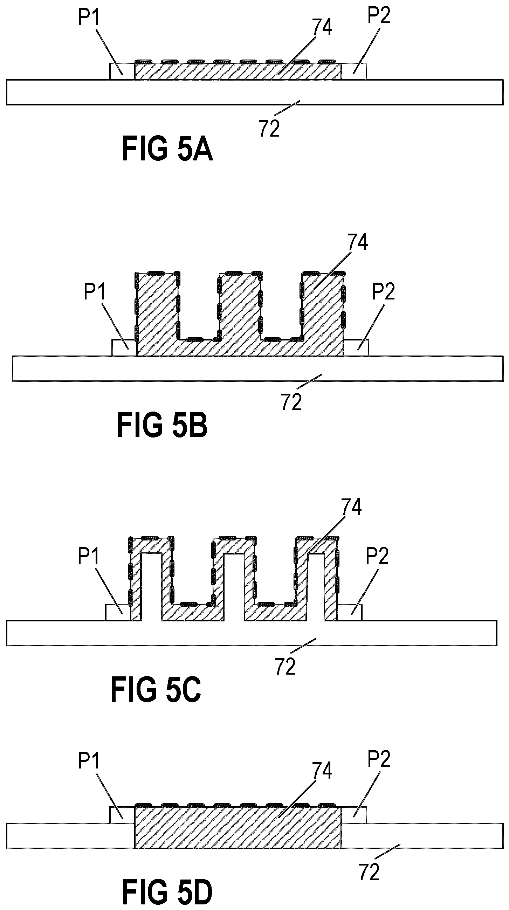

Now referring to Figure 5, wherein Figures 5A - 5C do not fall under the scope of the present invention and Figure 5D falls under the scope of the present invention, sections of housings according to embodiments of the disclosure are schematically illustrated. The housings combine the properties of different materials while it is still possible to produce them at comparably low costs. A housing 7 according to embodiments of the disclosure comprises a first layer 72 and a second layer 74. The first layer 72 forms at least the top of the housing 7 and, optionally, the sidewalls. The first layer 72, therefore, comprises a plurality of openings 722 (not specifically illustrated in Figure 5). The first layer 72 is formed from a first material which comprises certain material properties. The housing 7 further comprises a second layer 74 formed from a second material that comprises certain material properties. At least one of the material properties of the second material is different from the respective material property of the first material. In particular, the second material has a comparative tracking index CTI that is higher than a comparative tracking index CTI of the first material.

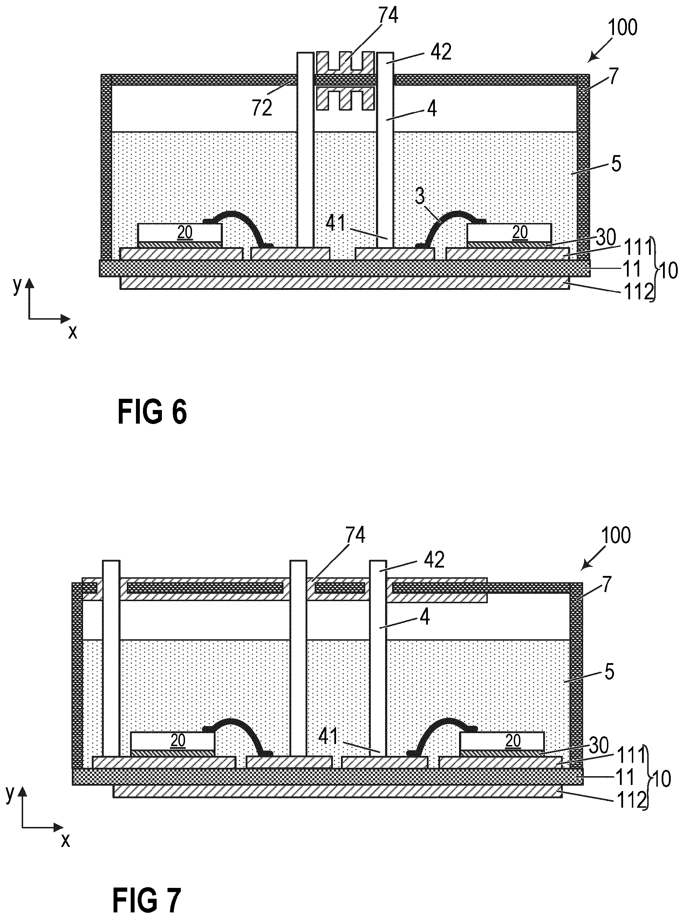

According to one example, the first material comprises a sufficiently high RTI and sufficient mechanical properties. The housing 7, therefore, generally fulfills the thermal and mechanical requirements. As has been discussed above, in order to reduce the overall costs of the housing, the first material may comprise a comparably low CTI. This would normally require comparably large distances d4 between terminal elements 4 (or any other elements) that are coupled to different electrical potentials P1, P2. In order to reduce the minimum distance dₘᵢₙ required between terminal elements 4 (or any other elements) that are coupled to different electrical potentials P1, P2 while still keeping the overall costs of the housing 7 comparably low, the second layer 74 is only arranged on some sections of the first layer 72. For example, the second layer 74 may be arranged in such sections of the housing 7 where a higher CTI is required in order to be able to arrange elements (e.g., terminal elements 4) that are coupled to different electrical potentials P1, P2 closer to each other.
The second layer 74, in order to keep the costs of the housing 7 low, is not necessarily arranged on the entire surface of the first layer 72. That is, it partly covers the first layer 72. It partly or at least partly covers at least one of a bottom surface of the first layer 72 and/or it partly or at least partly covers a top surface of the first layer 72. The bottom surface is a surface of the first layer 72 which, when the housing 7 is arranged to surround a substrate 10 faces the substrate 10 (the inside of the housing), and the top surface is a surface of the first layer 72 which, when the housing 7 is arranged to surround a substrate 10 faces the outside of the housing 7. In the examples illustrated in Figures 5A, 5B, and 5C, and which do not fall within the scope of the present invention, the second layer 74 partly covers only the top surface of the first layer 72. In the example illustrated in Figure 6, and which does not fall within the scope of the present invention, the second layer 74 partly covers the top surface and partly covers the bottom surface of the first layer 72. The second layer 74 may be a flat layer, as is schematically illustrated in Figure 5A. It is, however, also possible that the second layer 74 is an uneven layer 74 that forms trenches and/or protrusions (see Figure 5B), similar to what has been described with respect to Figure 4 above. Referring to Figure 5C, it is also possible that the first layer 72 is an uneven layer that forms trenches and/or protrusion, wherein the uneven first layer 72 is covered by a section of a (thin) second layer 74 at least in sections between two elements that are coupled to different potentials P1, P2. Referring to Figure 5D, which falls under the scope of the present invention, according to further alternative embodiments it is even possible that the first layer 72 be omitted in those parts of the housing 7 requiring a higher CTI. That is, the first layer 72 comprises at least one gap (or additional opening), each of the at least one gap being sealed by a section of the second layer 74 such that the second layer 74 forms at least one section of the housing 7. In this example it is also possible that the second layer 74 is a flat layer (as illustrated in Figure 5D) or an uneven layer (not specifically illustrated). In all of the different examples, the distance d4 between two elements that are coupled to different electrical potentials P1, P2 may be decreased even further. However, as the CTI of the second material is high with respect to the CTI of the first material, no or only few trenches or protrusions may generally be required. By arranging the second layer 74 only in some sections of the housing 7, the advantages of the first material and the second material may be combined for the concerned sections, while keeping the overall costs of the housing 7 comparably low. In the examples illustrated in Figures 5A to 5D, the second layer 74 is only arranged in sections of the housing 7 that are arranged between a first potential P1 and a second potential P2 that is different from the first potential P1.

Now referring to Figure 6, a cross-sectional view of a power semiconductor module arrangement 100 comprising a housing 7 according to embodiments of the disclosure is schematically illustrated. The power semiconductor module arrangement 100 essentially corresponds to the arrangement as has been described with respect to Figure 1 above. The housing 7, however, comprises a first layer 72 consisting of a first material having a first (comparably low) CTI, and a second layer 74 that partly covers the first layer 72, wherein the second layer 74 consists of a second material having a second CTI that is larger than the first CTI of the first material. The second layer 74 in the example of Figure 6 not falling within the scope of the present invention covers the first layer 72 in sections that are arranged between two neighboring terminal elements 4. In this way, the distance d4 between the two terminal elements 4 may be smaller as compared to the arrangement of Figure 1 where the housing 7 only comprises a single layer of material. The protrusions and trenches as illustrated in the second layer 74 in Figure 6, however, are optional.

Now referring to Figure 7, an even further embodiment of a power semiconductor module arrangement 100 is schematically illustrated. In this embodiment falling within the scope of the present invention, the second layer 74 covers large parts of the first layer 72, both on the top side and on the bottom side of the first layer 72. That is, some sections of the first layer 72 are sandwiched between portions of the second layer 74. The second layer 74, however, does not cover the entire first layer 72. That is, at least some parts of the first layer 72 are not covered by the second layer 74. The second layer 74, optionally, may also be arranged within one or more of the through holes 722. That is, parts of the second layer 74 may extend into the through holes 722 and may be arranged between the terminal elements 4 and the respective through holes 722 they protrude through. In this way, any gaps or spaces between the first layer 72 and the terminal element 4 may be sealed by the second layer 74 when a terminal element 4 extends through the opening 722. This may further increase the electrical isolation. At the same time, the through holes 722 are sealed by means of the second layer 74. In this way, any contaminants, moisture or corrosive gases, for example, may be prevented from entering the housing 7.

It is noted that in many power semiconductor modules, the bottom surface of the substrate 10 (surface facing away from the semiconductor bodies 20) is connected to ground potential. Therefore, the creepage distance between a terminal element 4 and ground potential is usually of highest interest. This is the case especially for high power semiconductor modules with isolation voltages of, e.g., 12kV or more. This similarly applies for spring contacts which are often used to press the power semiconductor module on a cooling unit (usually done at customer site) and which are usually connected to ground potential.

When the housing 7 is mounted on a power semiconductor module arrangement and at least one terminal element 4 protrudes through at least one of the openings 722, the first layer 72 may not be in direct contact with the at least one terminal element 4. For example, each of the openings 722 may have a round, square, or any other suitable cross-section, and the terminal element 4 may protrude centrally through the opening 722. The second layer 74 on the other hand may adjoin and directly contact one or more of the terminal elements 4. In this way, each of the plurality of openings 4 may be sealed to prevent air, contaminants, moisture and corrosive gases from entering the inside of the housing 7. The second layer 74 may be a continuous layer or a structured layer.

To even better protect the power semiconductor module arrangement 100 against corrosive gases, the second layer 74 may further include a reactant or additives, for example. The reactant may be configured to chemically react with corrosive gases, or, in particular, with sulfur or sulfur-containing compounds of corrosive gases. Corrosive gas may also be trapped, adsorbed or absorbed by the reactant. By chemically reacting with the corrosive gas, the reactant further prevents the harmful substances from reaching the (metal) components inside the housing 7 and thereby protects the components against corrosion. The reactant may be, for example, a powder of a third material which is distributed throughout the second material of the second layer 74. The third material may include any materials, e.g., metallic materials, which react with the corrosive gases and which may, e.g., form a metal sulfide when exposed to corrosive gases. The reactant may be essentially evenly distributed throughout the second material of the second layer 74. It is also possible to, e.g., add copper particles to the second material. Copper particles may act as sacrificial material and will react with hydrogen sulfide, for example, before it is able to reach the inside of the housing 7.

As has been described above, the first layer 72 comprises a first material and the second layer 74 comprises a second material that is different from the first material. According to embodiments of the disclosure, the first material can be a comparably rigid material. In this way, the housing 7 can provide sufficient protection against mechanical damage. Mechanical stability of the housing is also required, e.g., when mounting the semiconductor module including the housing to a cooling unit. The housing is usually used to press the substrate and/or a base plate against the cooling unit. A housing providing sufficient mechanical stability results in a substrate having sufficient contact to the cooling unit over the entire surface of the substrate to provide sufficient heat transfer between the substrate and the cooling unit. The second material, on the other hand, can be a material that is soft as compared to the first material. The second material can further comprise certain elastic properties. This allows the terminal elements 4 to penetrate through the second layer 74, for example, and to tightly close any gaps between the first layer 72 and the terminal elements 4. The first layer 72, for example, can comprise a thermoplastic material or any kind of hard plastic materials or epoxy. The second layer 74 can comprise at least one of soft polymers, silicones, (thermoplastic) elastomers, polyurethanes, acrylates, or rubbers, for example. According to one example, the second layer 74 consists of or comprises a liquid silicon rubber (LSR). A different material hardness of the first material and the second material may also improve the vibration robustness of the power semiconductor module arrangement 100, for example. Further, many rigid materials that may be used for the first layer 72 are very smooth and, therefore, may be difficult to handle manually. Materials that are comparably soft are generally much easier to handle, as they provide certain soft touch properties, especially when handled manually.

The housing 7 can be produced using (2K) injection molding, or manual assembly of separately produced injection molded or casted parts, for example. According to one example, a method for producing a housing 7 comprises, in a first step, forming a first layer 72 of a first material. The first layer 72 may have a rectangular or square cross-section, for example, and comprise a plurality of openings 722. According to one example, the plurality of openings 722 are distributed over the plane of the first layer 72 in a regular pattern. This, however, is only an example. The plurality of openings 722 can be distributed over the plane of the first layer 72 in any suitable way. The first layer 72 can be formed by means of an injection molding process, for example.

According to one example, the first layer 72 may remain in the mold and the second layer 74 is formed directly on the first layer 72 in the same mold. The second layer 74 is formed to partly cover the first layer 72. The second layer 74 may be arranged adjacent to and may directly adjoin the first layer 72, for example. When forming the first layer 72 and the second layer 74 by means of a 2K injection molding process, the second layer 74 generally adheres to the first layer 72 and may not be easily removed from the first layer 72. The second layer 74 generally may adhere to the first layer, e.g., by means of chemical bonding, mechanical interlock and/or any other suitable connection method. Depending on the materials used for the first layer 72 and the second layer 74, a chemical bond may be formed between the layers 72, 74, for example. According to one example, the second layer 74 has a certain adhesiveness such that it adheres to the first layer 72 to a certain degree without the need for any mechanical interlocks.

In order to form a power semiconductor module arrangement, the top that is formed by means of methods according to embodiments of the disclosure may be connected to sidewalls in order to form a housing 7 that is then arranged to enclose at least one substrate 10. The sidewalls, however, may also be formed during the same injection molding process as the top of the housing 7.

Before inserting a terminal element 4 into an opening 722, the second layer 74 may completely cover the opening 722. According to one example, a thickness of the second layer 74 in the vertical direction y may be smaller in the range of the openings 722 as compared to a thickness of the second layer 74 in the same direction in those sections where it covers the bottom surface of the first layer 72. In this way a kind of membrane can be formed, which covers the respective opening 722. A terminal element 4 can easily penetrate through such a membrane when inserting it through the opening 722. The opening 722, however, is still sufficiently sealed after inserting the terminal element 4. That is, the sealing between the terminal element 4 and the second layer 74 may be realized by the penetration of the terminal element 4 through the second layer 74 and the elastic behavior of the material of the second layer 74. When penetrating through the second layer 74, the second end 42 of the terminal element 4 opens a small hole in the second layer 74. After this initial hole has been formed, the material of the second layer 74 elastically moves to allow the terminal element 4 to advance further through the hole. When the terminal element 4 is in its final position, the material of the second layer 74 due to its elastic properties forms a tight collar around the terminal element 4. Optionally, the second layer 74 can have specific structures such as, e.g., predetermined breaking points, to allow for a controlled rupture by the terminal element 4. According to other examples, terminal elements 4 may also be molded into the housing 7 when forming the housing 7 by means of an injection molding process.

## Claims

1. A housing (7) for a power semiconductor module arrangement (100) comprises sidewalls and a top, wherein the top comprises:
a first layer (72) of a first material comprising a plurality of openings (722); and
a second layer (74) of a second material that is different from the first material,
wherein
the second material has a comparative tracking index CTI that is higher than a comparative tracking index CTI of the first material, and at least one of
the second layer (74) partly covers at least one of a bottom surface of the first layer (72) and a top surface of the first layer (72), and
the first layer (72) comprises at least one additional opening, each of the at least one additional opening being sealed by a section of the second layer (74) such that the second layer (74) forms at least one section of the housing (7).

2. The housing (7) of claim 1, wherein the second material is softer than the first material.

3. The housing (7) of claim 1 or 2, wherein
the first material comprises at least one of a thermoplastic material, a plastic material and epoxy, and
the second material comprises at least one of a liquid silicon rubber, a soft polymer, a silicone, an elastomer, a thermoplastic elastomer, polyurethane, acrylate, and rubber.

4. The housing (7) of any of the preceding claims, wherein parts of the second layer (74) extend into at least some of the openings (722), thereby sealing the respective openings (722).

5. The housing (7) of any of the preceding claims, wherein at least one of
the second layer (74) comprises one or more protrusions and/or trenches extending in a vertical direction (y) perpendicular to the top and bottom surface of the first layer (72), and
the first layer (72) comprises one or more protrusions and/or trenches extending in the vertical direction (y), and wherein the one or more protrusions and/or trenches are covered by a section of the second layer (74).

6. The housing (7) of any of the preceding claims, wherein the second layer (74) is a structured layer that includes recesses between different sections of the layer.

7. The housing (7) of any of the preceding claims, wherein the second layer (74) adheres to the first layer (72).

8. A power semiconductor module arrangement (100) comprising:
a semiconductor substrate (10);
at least one semiconductor body (20) arranged on a top surface of the semiconductor substrate (10); and
a housing (7) according to any of claims 1 to 7, wherein the semiconductor substrate (10) with the at least one semiconductor body (20) arranged thereon is arranged within the housing (7) or forms a bottom of the housing (7).

9. The power semiconductor module arrangement (100) of claim 8, wherein the second layer (74) covers sections of the housing (7) or forms sections of the housing (7) that are arranged between a first potential (P1) and a second potential (P2) that is different from the first potential (P1).

10. The power semiconductor module arrangement (100) of claim 9, further comprising a plurality of terminal elements (4), wherein
a first end (41) of each of the plurality of terminal elements (4) is mechanically and electrically coupled to the substrate (10);
a second end (42) of each of plurality of terminal elements (4) protrudes through one of the openings (722) in the first layer (72) to the outside of the housing (7);
at least one of the plurality of terminal elements (4) is electrically coupled to the first potential (P1);
at least one of the plurality of terminal elements (4) is electrically coupled to the second potential (P2); and
the second layer (74) at least covers sections of the first layer (72) or forms sections of the housing (7) that are arranged between the at least one terminal element (4) electrically coupled to the first potential (P1) and the at least one terminal element (4) electrically coupled to the second potential (P2).

11. A method for forming a top of a housing (7), the method comprising:
forming a first layer (72) of a first material comprising a plurality of openings (722); and
forming a second layer (74) of a second material that is different from the first material, wherein
the second material has a comparative tracking index CTI that is higher than a comparative tracking index CTI of the first material, and at least one of
the second layer (74) partly covers at least one of a bottom surface of the first layer (72) and a top surface of the first layer (72), and
the first layer (72) comprises at least one additional opening, each of the at least one additional opening being sealed by a section of the second layer (74) such that the second layer (74) forms at least one section of the housing (7).

12. The method of claim 11, wherein
forming the first layer (72) comprises forming the first layer (72) in a mold; and
forming the second layer (74) comprises, after forming the first layer (72), forming the second layer (74) in the same mold.

## Patentansprüche

1. Gehäuse (7) für eine Leistungshalbleitermodulanordnung (100), das Seitenwände und eine Oberseite umfasst, wobei die Oberseite Folgendes umfasst:
eine erste Schicht (72) aus einem ersten Material, welche mehrere Öffnungen (722) umfasst; und
eine zweite Schicht (74) aus einem zweiten Material, das sich von dem ersten Material unterscheidet, wobei
das zweite Material einen Comparative Tracking Index CTI aufweist, der höher als ein Comparative Tracking Index CTI des ersten Materials ist, und
die zweite Schicht (74) teilweise eine untere Oberfläche der ersten Schicht (72) und/oder eine obere Oberfläche der ersten Schicht (72) bedeckt und/oder
die erste Schicht (72) mindestens eine zusätzliche Öffnung umfasst, wobei jede der mindestens einen zusätzlichen Öffnung durch einen Abschnitt der zweiten Schicht (74) versiegelt ist, sodass die zweite Schicht (74) mindestens einen Abschnitt des Gehäuses (7) bildet.

2. Gehäuse (7) nach Anspruch 1, wobei das zweite Material weicher als das erste Material ist.

3. Gehäuse (7) nach Anspruch 1 oder 2, wobei
das erste Material thermoplastisches Material und/oder Kunststoff und/oder Epoxid umfasst und
das zweite Material ein Flüssig-Silikon und/oder ein weiches Polymer und/oder ein Silikon und/oder ein Elastomer und/oder ein thermoplastisches Elastomer und/oder Polyurethan und/oder Acrylat und/oder Gummi umfasst.

4. Gehäuse (7) nach einem der vorhergehenden Ansprüche, wobei sich Teile der zweiten Schicht (74) in mindestens einige der Öffnungen (722) erstrecken, wodurch die jeweiligen Öffnungen (722) versiegelt werden.

5. Gehäuse (7) nach einem der vorhergehenden Ansprüche, wobei
die zweite Schicht (74) einen oder mehrere Vorsprünge und/oder Gräben umfasst, die sich in einer vertikalen Richtung (y) senkrecht zu der oberen und unteren Oberfläche der ersten Schicht (72) erstrecken, und/oder
die erste Schicht (72) einen oder mehrere Vorsprünge und/oder Gräben umfasst, die sich in der vertikalen Richtung (y) erstrecken, und wobei der eine oder die mehreren Vorsprünge und/oder Gräben durch einen Abschnitt der zweiten Schicht (74) bedeckt sind.

6. Gehäuse (7) nach einem der vorhergehenden Ansprüche, wobei die zweite Schicht (74) eine strukturierte Schicht ist, die Vertiefungen zwischen verschiedenen Abschnitten der Schicht beinhaltet.

7. Gehäuse (7) nach einem der vorhergehenden Ansprüche, wobei die zweite Schicht (74) an der ersten Schicht (72) haftet.

8. Leistungshalbleitermodulanordnung (100), umfassend:
ein Halbleitersubstrat (10);
mindestens einen Halbleiterkörper (20), der auf einer oberen Oberfläche des Halbleitersubstrats (10) angeordnet ist;
ein Gehäuse (7) nach einem der Ansprüche 1 bis 7, wobei das Halbleitersubstrat (10) mit dem mindestens einen darauf angeordneten Halbleiterkörper (20) innerhalb des Gehäuses (7) angeordnet ist oder eine Unterseite des Gehäuses (7) bildet.

9. Leistungshalbleitermodulanordnung (100) nach Anspruch 8, wobei die zweite Schicht (74) Abschnitte des Gehäuses (7) bedeckt oder Abschnitte des Gehäuses (7) bildet, die zwischen einem ersten Potenzial (P1) und einem zweiten Potential (P2), das sich von dem ersten Potenzial (P1) unterscheidet, angeordnet sind.

10. Leistungshalbleitermodulanordnung (100) nach Anspruch 9, ferner umfassend mehrere Anschlusselemente (4), wobei
ein erstes Ende (41) jedes der mehreren Anschlusselemente (4) mechanisch und elektrisch mit dem Substrat (10) gekoppelt ist;
ein zweites Ende (42) jedes der mehreren Anschlusselemente (4) durch eine der Öffnungen (722) in der ersten Schicht (72) zur Außenseite des Gehäuses (7) vorsteht;
mindestens eines der mehreren Anschlusselemente (4) elektrisch mit dem ersten Potenzial (P1) gekoppelt ist; mindestens eines der mehreren Anschlusselemente (4) elektrisch mit dem zweiten Potenzial (P2) gekoppelt ist; und
die zweite Schicht (74) mindestens Abschnitte der ersten Schicht (72) bedeckt oder Abschnitte des Gehäuses (7) bildet, die zwischen dem mindestens einen elektrisch mit dem ersten Potenzial (P1) gekoppelten Anschlusselement (4) und dem mindestens einen elektrisch mit dem zweiten Potenzial (P2) gekoppelten Anschlusselement (4) angeordnet sind.

11. Verfahren zum Bilden einer Oberseite eines Gehäuses (7), wobei das Verfahren Folgendes umfasst:
Bilden einer ersten Schicht (72) aus einem ersten Material, welche mehrere Öffnungen (722) umfasst; und
Bilden einer zweiten Schicht (74) aus einem zweiten Material, das sich von dem ersten Material unterscheidet, wobei
das zweite Material einen Comparative Tracking Index CTI aufweist, der höher als ein Comparative Tracking Index CTI des ersten Materials ist, und
die zweite Schicht (74) teilweise eine untere Oberfläche der ersten Schicht (72) und/oder eine obere Oberfläche der ersten Schicht (72) bedeckt und/oder
die erste Schicht (72) mindestens eine zusätzliche Öffnung umfasst, wobei jede der mindestens einen zusätzlichen Öffnung durch einen Abschnitt der zweiten Schicht (74) versiegelt ist, sodass die zweite Schicht (74) mindestens einen Abschnitt des Gehäuses (7) bildet.

12. Verfahren nach Anspruch 11, wobei
das Bilden der ersten Schicht (72) das Bilden der ersten Schicht (72) in einer Form umfasst; und
das Bilden der zweiten Schicht (74) das Bilden der zweiten Schicht (74) in derselben Form nach dem Bilden der ersten Schicht (72) umfasst.

## Revendications

1. Un boîtier (7) d'un agencement (100) de module à semiconducteur de puissance comprend des parois latérales et un sommet, dans lequel le sommet comprend :
une première couche (72) d'un premier matériau comprenant une pluralité d'ouvertures (722) ; et
une deuxième couche (74) d'un deuxième matériau, qui est différent du premier matériau,
dans lequel
le deuxième matériau a un indice de suivi comparatif CTI, qui est plus grand qu'un indice de suivi comparatif CTI du premier matériau, et au moins l'une de
la deuxième couche (74) recouvre partiellement au moins l'une d'une surface de fond de la première couche (72) et d'une surface de sommet de la première couche (72), et
la première couche (72) comprend au moins une ouverture supplémentaire, chacune de la au moins une ouverture supplémentaire étant scellée par une partie de la deuxième couche (74) de manière à ce que la deuxième couche (74) forme au moins une partie du boîtier (7).

2. Le boîtier (7) de la revendication 1, dans lequel le deuxième matériau est plus souple que le premier matériau.

3. Le boîtier (7) de la revendication 1 ou 2, dans lequel
le premier matériau comprend au moins l'un d'un matériau thermoplastique, d'une matière plastique et d'un époxy, et
le deuxième matériau comprend au moins l'un d'un caoutchouc de silicone liquide, d'un polymère souple, d'une silicone, d'un élastomère, d'un élastomère thermoplastique, d'un polyuréthane, d'un acrylate et d'un caoutchouc.

4. Le boîtier (7) de l'une quelconque des revendications précédentes, dans lequel des parties de la deuxième couche (74) s'étendent dans au moins certaines des ouvertures (722), en scellant ainsi les ouvertures (722) respectives.

5. Le boîtier (7) de l'une quelconque des revendications précédentes, dans lequel au moins l'une de
la deuxième couche (74) comprend une ou plusieurs saillies et/ou tranchées s'étendant dans une direction (y) verticale perpendiculaire à la surface de sommet et de fond de la première couche (72), et
la première couche (72) comprend une ou plusieurs saillies et/ou tranchées s'étendant dans la direction (y) verticale, et dans lequel la une ou les plusieurs saillies et/ou tranchées sont recouvertes par une partie de la deuxième couche (74).

6. Le boîtier (7) de l'une quelconque des revendications précédentes, dans lequel la deuxième couche (74) est une couche structurée, qui comprend des creux entre des parties différentes de la couche.

7. Le boîtier (7) de l'une quelconque des revendications précédentes, dans lequel la deuxième couche (74) adhère à la première couche (72).

8. Un agencement (100) de module à semiconducteur de puissance comprenant :
un substrat (10) à semiconducteur ;
au moins un corps (20) à semiconducteur disposé sur une surface de sommet du substrat (10) à semiconducteur ; et
un boîtier (7) suivant l'une quelconque des revendications 1 à 7, dans lequel le substrat (10) à semiconducteur est, avec le au moins un corps (20) à semiconducteur disposé sur lui, disposé dans le boîtier (7) ou forme un fond du boîtier (7).

9. L'agencement (100) de module à semiconducteur de puissance de la revendication 8, dans lequel la deuxième couche (74) recouvre des parties du boîtier (7) ou forme des parties du boîtier (7), qui sont montées entre un premier potentiel (P1) et un deuxième potentiel (P2), qui est différent du premier potentiel (P1).

10. L'agencement (100) de module à semiconducteur de puissance de la revendication 9, comprenant en outre une pluralité d'éléments (4) de borne, dans lequel
une première extrémité (41) de chacun de la pluralité d'éléments (4) de borne est assemblée mécaniquement et est connectée électriquement au substrat (10) ;
une deuxième extrémité (42) de chacun de la pluralité d'éléments (4) de borne fait saillie à l'extérieur du boîtier (7) en passant par l'une des ouvertures (722) de la première couche (72) ;
au moins l'un de la pluralité d'éléments (4) de borne est connecté électriquement au premier potentiel (P1) ;
au moins l'un de la pluralité d'éléments (4) de borne est connecté électriquement au deuxième potentiel (P2) ; et
la deuxième couche (74) recouvre au moins en partie des parties de la première couche (72) ou forme des parties du boîtier (7), qui sont montées entre le au moins un élément (4) de borne connecté électriquement au premier potentiel (P1) et le au moins un élément (4) de borne connecté électriquement au deuxième potentiel (P2).

11. Un procédé de formation du sommet d'un boîtier (7), le procédé comprenant :
former une première couche (72) d'un premier matériau comprenant une pluralité d'ouvertures (722) ; et
former une deuxième couche (74) d'un deuxième matériau, qui est différent du premier matériau, dans lequel
le deuxième matériau a un indice de suivi comparatif CTI, qui est plus grand qu'un indice de suivi comparatif CTI du premier matériau, et au moins l'une de
la deuxième couche (74) recouvre partiellement au moins l'une d'une surface de fond de la première couche (72) et d'une surface de sommet de la première couche (72), et
la première couche (72) comprend au moins une ouverture supplémentaire, chacune de la au moins une ouverture supplémentaire étant scellée par une partie de la deuxième couche (74) de manière à ce que la deuxième couche (74) forme au moins une partie du boîtier (7).

12. Le procédé de la revendication 11, dans lequel
former la première couche (72) comprend former la première couche (72) dans un moule ; et
former la deuxième couche (74) comprend, après avoir formé la première couche (72), former la deuxième couche (74) dans le même moule.
